# EUROPÄISCHE PATENTSCHRIFT

(11) **EP 0 640 879 B1**
(45) Veröffentlichungstag und Bekanntmachung des Hinweises auf die Patenterteilung: **27.11.1996**
(21) Anmeldenummer: 94112673.2
(22) Anmeldetag: 13.08.1994
(51) Int. Cl.: G03F 7/34, G03F 7/28

(54) **Tonbares strahlungsempfindliches Gemisch und Verfahren zur Herstellung von Mehrfarbenbildern mittels solch eines Gemisches**
Tonable photosensitive composition and process for making polychromatic images by means of such a composition
Composition photosensible pigmentable et procédé pour réaliser des images polychromes au moyen d'une telle composition

(30) Priorität: 24.08.1993 DE 4328348
(43) Veröffentlichungstag der Anmeldung: 01.03.1995
(73) Patentinhaber: DU PONT DE NEMOURS (DEUTSCHLAND) GMBH, 61343 Bad Homburg v.d.H. (DE); E.I. DU PONT DE NEMOURS AND COMPANY, Wilmington Delaware 19898 (US)
(72) Erfinder: Grossa, Mario, Dr., D-63303 Dreieich (DE); Sondergeld, Manfred, Dr., D-63165 Mühlheim (DE)
(74) Vertreter: Pistor, Wolfgang

(56) Entgegenhaltungen:
- EP-A- 0 243 932
- WO-A-91/06424
- US-A- 4 326 010

## Beschreibung

Gegenstand der vorliegenden Anmeldung ist ein tonbares strahlungsempfindliches Gemisch enthaltend als wesentliche Bestandteile eine Verbindung, deren Umsetzung durch Bestrahlung mit aktinischer Strahlung Änderungen der Klebrigkeit des Gemischs hervorruft, und einer die Adhäsionseigenschaften des Gemischs beeinflussenden Verbindung.

In der Reproduktionstechnik werden bekanntlich gerasterte Farbauszüge als Kopiervorlagen für die Herstellung von Offset- oder Hochdruckplatten verwendet. Bevor die Belichtung der Druckplatten erfolgt, werden die Farbauszüge mit Hilfe von Farbprüfverfahren daraufhin überprüft, ob das spätere Druckergebnis eine tonwertrichtige Reproduktion der Vorlage darstellt.

In solchen Farbprüfverfahren finden strahlungsempfindliche Aufzeichnungsmaterialien Verwendung, bei denen zur Bilderzeugung Unterschiede in der Klebrigkeit der belichteten und unbelichteten Bereiche der strahlungsempfindlichen Schicht ausgenutzt werden.

So ist z.B. aus den deutschen Patentschriften 12 10 321, 19 04 058, 19 04 059 und 20 04 214 und der US 43 56 253 und der EP-A 02 43 933 ein Reproduktionsverfahren bekannt, bei dem ein klebriges photopolymerisierbares Aufzeichnungsmaterial, bestehend aus einem Schichtträger und einer photopolymerisierbaren Schicht, die mindestens ein additionspolymerisierbares Monomeres und einen Photopolymerisationsinitiator enthält, durch bildmäßige Belichtung gehärtet wird, wobei die belichteten Bildteile ihre Klebrigkeit verlieren. Das latente Bild wird dann durch Aufbringen geeigneter Tonermaterialien sichtbar gemacht, die nur an den unbelichteten, klebrigen Stellen haften, während sie von den belichteten, nicht klebenden Bildteilen nach dem Aufbringen wieder entfernt werden können. Nach diesem Verfahren erhält man positive, gegebenenfalls gefärbte Bilder der Vorlage, die im Aussehen Bildern gleichen, die unter Verwendung von Druckfarben hergestellt wurden.

Negative Bilder der Vorlage erhält man, wenn man die z.B. in den deutschen Patentschriften 27 58 209, 30 23 247 und 34 29 615 beschriebenen lichtempfindlichen Materialien verwendet. Diese Aufzeichnungsmaterialien enthalten als lichtempfindliche Komponente entweder eine Dihydropyridinverbindung oder ein System aus einer Dihydropyridinverbindung und einer Hexarylbisimidazolverbindung.

Das Aufbringen der überwiegend aus feinteiligen Pulvern bestehenden Tonermaterialien kann durch Bestäuben der bildmäßig belichteten Oberfläche mit dem Toner erfolgen, wie sie z.B. in DE-C 29 46 896 und US-A 39 09 282 beschrieben sind. Nach einer anderen Ausführungsform kann sich der Toner auch lose gebunden auf einem gesonderten Träger befinden und durch Inkontaktbringen dieses Trägers mit der bildmäßig belichteten Schicht übertragen werden. Solche pigmentierten Trägerschichten werden in DE-C 36 25 014 und DE-C 39 41 493 beschrieben.

Die strahlungsempfindlichen Aufzeichnungsmaterialien bestehen üblicherweise aus einem Schichtträger, einer strahlungsempfindlichen Schicht und einer Deckfolie. Diese Deckfolie wird abgezogen und das Material auf ein Bildempfangsmaterial auflaminiert bevor die bildmäßige Belichtung erfolgt. Der Schichtträger kann je nach Material vor oder nach der Belichtung abgezogen werden.

Ein immer wieder auftretendes Problem bei diesen Verfahren ist, daß durch eine zu hohe Haftung der strahlungsempfindlichen Schicht an der Deckfolie sich diese vor der Laminierung auf den Bildträger nicht einwandfrei abziehen läßt. Hierbei kann sich die strahlungsempfindliche Schicht teilweise von dem Schichtträger lösen, oder Teilbereiche der Schicht werden von der Deckfolie herausgerissen. Solch beschädigte Schichten können selbstverständlich für Farbprüfverfahren nicht mehr verwendet werden.

Durch den Zusatz von aliphatischen Polyestern mit Molekulargewichten zwischen 1 500 und 40 000, wie er in der US 43 26 010 beschrieben ist, kann die Haftungsbalance der strahlungsempfindlichen Schicht zwischen Deckfolie und Schichtträger zwar etwas verbessert werden, jedoch bleiben andere Schwierigkeiten des so hergestellten strahlungsempfindlichen Aufzeichnungsmaterials bestehen. Nach der Produktion des strahlungsempfindlichen Aufzeichnungsmaterials bildet sich die Haftungsbalance erst innerhalb eines Zeitraums von 2 bis 10 Wochen aus. Dies führt zu einer unerwünschten Lagerung und verzögerten Auslieferung des strahlungsempfindlichen Aufzeichnungsmaterials sowie zu zusätzlichen Qualitätskontrollen. Desweiteren sind die zur Herstellung der strahlungsempfindlichen Aufzeichnungsmaterialien notwendigen Konzentrationen der Polyester in der Gießlösung sehr stark von der Schichtdicke des zu gießenden strahlungsempfindlichen Aufzeichnungsmaterials abhängig. Dadurch ist es unmöglich, aus einer einheitlichen Gießlösung strahlungsempfindlichen Aufzeichnungsmaterialien in verschiedenen Schichtdicken zwischen 2 µm und 20 µm herzustellen. Dies erhöht durch die Bereitstellung jeweils neuer Gießlösungen den Aufwand bei dem entsprechenden Produktwechsel.

Überdies wird durch den Zusatz von aliphatischen Polyestern mit Molekulargewichten zwischen 1 500 und 40 000, wie er in der US 43 26 010 beschrieben ist, die Auswahl der Folien für die Deckfolie eingeschränkt, da Polypropylenfolien verschiedener Hersteller oder Herstellungsverfahren unterschiedliche Hafteigenschaften gegenüber der tonbaren strahlungsempfindlichen Schicht aufweisen.

Ein weiterer Nachteil des in US 43 26 010 beschriebenen strahlungsempfindlichen Aufzeichnungsmaterials liegt in der starken Temperaturabhängigkeit der Haftungsbalance. Dies führt schon bei einer Temperatur von 45° C des tonbaren strahlungsempfindlichen Aufzeichnungsmaterials zu einer Absenkung der Haftung gegenüber dem Schichtträger und damit zum Herausreißen von Teilbereichen der strahlungsempfindlichen Schicht oder zum teilweisen Lösen der strahlungsempfindlichen Schicht von der Trägerfolie. Solch beschädigte Schichten können selbstverständlich für Farbprüfverfahren nicht mehr verwendet werden.

Aufgabe der vorliegenden Erfindung ist es daher, die genannten Probleme bei Farbprüfverfahren zu beseitigen und das Herstellungsverfahren der entsprechenden strahlungsempfindlichen Aufzeichnungsmaterialien zu vereinfachen.

Notwendige Randbedingung dabei ist, daß eine Haftungsbalance eines tonbaren strahlungsempfindlichen Gemischs zu einer Deckfolie und einer Trägerschicht in der Form besteht, so das die Deckfolie selektiv als erste abgezogen werden kann und die Trägerschicht aber auch abziehbar bleibt, wobei die Aufzeichnungsschicht in beiden Fällen nicht beschädigt wird und außerdem die Haftung der Aufzeichnungsschicht auf einem Bildempfangsmaterial bzw. auf weiteren Aufzeichnungsschichten nicht beeinflußt wird und ein einwandfreier Tonerauftrag auf die bildmäßig belichtete Schicht gewährleistet ist. Diese Eigenschaften müssen innerhalb eines Temperaturbereiches von 15° C - 60° C gewährleistet sein.

Ein Teil der Aufgabe der vorliegenden Erfindung ist es, ein tonbares strahlungsempfindliches Gemisch bereitzustellen, welches aus einer einheitlichen Rezeptur in verschiedenen Schichtdicken im Bereich von 2 µm - 20 µm produziert werden kann.

Ein weiterer Teil der Aufgabe der Erfindung ist es, ein tonbares strahlungsempfindliches Gemisch bereitzustellen, welches weniger als eine Woche zur Ausbildung der Haftungsbalance benötigt und somit direkt nach der Herstellung ausgeliefert werden kann.

Ein weiterer Teil der Aufgabe der vorliegenden Erfindung ist es, ein tonbares strahlungsempfindliches Gemisch bereitzustellen, welches Polypropylenfolien aus verschiedenen Herstellungsverfahren als Deckfolie verwenden kann.

Diese Aufgabe wird gelöst durch ein tonbares strahlungsempfindliches Gemisch gemäß Anspruch 1 oder 2 und ein Verfahren zur Herstellung eines Farbbildes unter Verwendung solch eines Gemischs wie es in Anspruch 9 beschrieben ist.

Geeignete Hilfsmittel zur Steuerung der Adhäsionseigenschaften von tonbaren strahlungsempfindlichen Aufzeichnungsschichten sind erfindungsgemäß Polycaprolactone mit einem mittleren Molekulargewicht von mindestens 50 000.

Besonders gut geeignet sind Polycaprolactone mit einem mittleren Molekulargewicht zwischen 50 000 und 250 000. Ganz besonders gut geeignet sind Polycaprolactone mit einem mittleren Molekulargewicht zwischen 70 000 und 180 000, wobei solche mit einem mittleren Molekulargewicht zwischen 100 000 und 130 000 am besten geeignet sind. Diese Polycaprolactone können sowohl als alleiniges Adhäsionsadditiv verwendet werden als auch in Kombination mit anderen solcher Zusätzen. Besonders bevorzugt ist jedoch der Einsatz dieser Polycaprolactone als alleiniges Additiv zur Steuerung der Adhäsionseigenschaften.

Die erfindungsgemäßen tonbaren strahlungsempfindlichen Gemische sollten 0,05 bis 5,0 Gew.% der Polycaprolactone mit einem mittleren Molekulargewicht von mindestens 50 000 enthalten. Besonders bevorzugt ist jedoch der Bereich von 0,05 bis 2,0 Gew.%.

Als tonbare strahlungsempfindliche Gemische im Sinne dieser Erfindung können sowohl positiv tonbare, photohärtbare Systeme, wie sie z.B. in DE-C 12 10 321, DE-C 19 04 058 oder DE-C 20 04 214 genannt sind, als auch negativ tonbare, bei Bestrahlung klebrig werdende Systeme, wie sie z.B. in DE-C 27 58 209, DE-C 30 23 247 und DE-C 34 29 615 beschrieben sind, verwendet werden. Die genannten negativ tonbaren Aufzeichnungsmaterialien enthalten entweder eine Dihydropyridinverbindung oder ein lichtempfindliches System aus einer Hexarylbisimidazolverbindung und einem Dihydropyridin.

Bevorzugt werden aber positiv tonbare photopolymersierbare Aufzeichnungsmaterialien für die vorliegende Erfindung verwendet. Insbesondere die in EP-A 02 43 932 und EP-A 02 43 933 beschriebenen Materialien werden bevorzugt eingesetzt. Diese Materialien enthalten ein polymeres Bindemittel, mindestens eine photopolymersierbare Verbindung, einen Photoinitiator und ggf. weitere Hilfsstoffe wie Weichmacher, Sensibilisatoren, Füllstoffe, Antioxidantien und optische Aufheller. Bevorzugte Bindemittel sind die in der EP-A 02 43 933 genannten Polymere mit einer Glastemperatur < 70° C, bzw. < 80° C bei Polymergemischen, und mit salzbildenden Gruppen, welche durch Metallionen ionisch vernetzt sind. Besonders bewährt haben sich thermoplastische Bindemittel auf Acrylat und/oder Methacrylatbasis, die die salzbildenden Gruppen z.B. in Form von Acrylsäure oder Methacrylsäure enthalten. Die Metallionen sind bevorzugt Magnesium, Calcium, Strontium, Barium, Aluminium, Zinn, Zink, Cadmium, Titan, Zirkon und Mangan, die als Salze, bevorzugt als Chelate zugesetzt werden.

Die Menge des Bindemittels bzw. des Bindemittelgemischs beträgt im allgemeinen 20 - 90 Gew.%, vorzugsweise 30 - 70 Gew.%, bezogen auf die Gesamtmasse der getrockneten Aufzeichnungsschicht. Der Gehalt an salzbildenden Gruppen beträgt 2 - 20 Gew.%, vorzugsweise 2 - 15 Gew. %, wobei mindestens 10 Gew.% dieser Gruppen durch die Metallionen vernetzt sein sollten.

Als photopolymerisierbare Verbindungen eignen sich die bekannten Monomeren und Oligomeren. Bevorzugt werden Verbindungen mit mehreren additionspolymersierbaren, ethylenisch ungesättigten Gruppen verwendet. Es sind auch Kombinationen dieser Verbindungen möglich. Besonders geeignet sind Acryl- und Methacrylsäureester von mehrwertigen alicyclischen und cyclischen Polyolen sowie aromatischen Hydroxyverbindungen, wie z.B. Ethylendiacrylat, Diethylenglykoldiacrylat, Glycerin-di- und -triacrylat, 1,3-Propandioldimethacrylat, Trimethylolpropantrimethacrylat, Hexamethylenglykoldiacrylat, und die Bisacrylate und Bismethacrylate von Bisphenol-A, dessen alkoxylierten sowie durch Umsetzung mit Epichlorhydrin erhaltenen Derivaten wie sie z.B. in EP-A 02 43 932 beschrieben sind. Die Monomere werden üblicherweise in Mengen von 10 bis 80 Gew.%, bevorzugt 20 bis 60 Gew.%, verwendet.

Als Photoinitiatoren können praktisch alle für diesen Zweck bekannten Verbindungen in Mengen von 0,01 bis 15 Gew.% verwendet werden. Als Beispiele geeigneter Photoinitiatoren und Photoinitiatorsystemen seien genannt: Benzil, Benzildimethylketal, Benzoin, Benzoinisopropylether, α-Methylbenzoin, 1,4-Naphthochinon, Michler's Keton und Benzophenon, sowie Systeme aus substituierten Thioxanthonen und tertiären Aminen.

Desweiteren können 5 - 30 Gew.% eines oder mehrerer Weichmacher verwendet werden, z.B. Alkylphosphate, Polyethylenglykole, Polyhydroxyethylenglykolether, Diester von Phthalsäure, Adipinsäure und Capronsäure. Bevorzugt werden flüssige Acrylat- bzw. Methacrylatpolymere oder Butadien/Acrylnitril-Copolymere mit salzbildenden Gruppen verwendet.

Die tonbaren strahlungsempfindlichen Gemische können nach bekannten Methoden auf geeignete vorzugsweise transparente, Schichtträger aufgetragen und anschließend getrocknet werden. Geeignete Schichtträger sind beispielsweise Kunststoffolien aus Polyethylen, Polypropylen, Polyamid und Polyester. Bevorzugt wird eine Polyethylenterephthalatfolie verwendet.

Bei der Verwendung von nichttransparenten Schichtträgern, werden diese vor der bildmäßigen Belichtung abgezogen.

Die Seite der Aufzeichnungsschicht, die dem Schichtträger abgewandt ist, wird mit einer flexiblen Deckschicht, beispielsweise einer dünnen Folie aus Polystyrol, Polyethylen, Polypropylen oder Polyethylenterephthalat versehen. Bevorzugt wird eine Polypropylenfolie verwendet.

Die Schichtdicke der Aufzeichnungsschicht kann je nach gewünschter Anwendung zwischen 2 µm und 0,1 mm liegen.

Die strahlungsempfindlichen Materialien besitzen ihre maximale Empfindlichkeit im UV-Bereich, bevorzugt im Wellenlängenbereich zwischen 250 und 450 nm. Zur Belichtung sind daher alle Strahlungsquellen geeignet, die eine wirksame Menge dieser Strahlung liefern; beispielsweise Xenonlampen, Quecksilberdampflampen und Kohlebogenlampen, Laser Fluoreszenzlampen mit UV-Strahlung emittierenden Leuchtstoffen und Elektronenblitzgeräten.

Das Tonen der bildmäßig belichteten Aufzeichnungsschicht kann sowohl durch Bestäuben mit überwiegend aus feinteiligen Pulvern bestehenden Tonermaterialien erfolgen, wie sie z.B. aus DE-C 29 46 896 und US 39 09 282 bekannt sind, wie auch mit pigmentierten Tonungsfolien, die das Tonermaterial lose gebunden auf einem gesonderten Träger enthalten. Solche Tonungsfolien werden z.B. in DE-C 39 41 493 und DE-C 36 25 014 und DE-C 37 06 528 beschrieben.

Das erfindungsgemäße Gemisch kann z.B. mit Vorteil zur Wiedergabe von Strich- und Rasteraufnahmen für die Anwendung in graphischen und anderen industriellen Bereichen verwendet werden. Das Hauptanwendungsgebiet liegt jedoch in der Herstellung von Ein- und Mehrfarbenbildern und in der Verwendung für Farbprüfverfahren.

Die Durchführung eines Farbprüfverfahrens gemäß der vorliegenden Erfindung kann die folgenden Verfahrensschritte umfassen.

Nach dem Entfernen der Deckfolie wird ein positiv tonbares photopolymerisierbares Aufzeichnungsmaterial auf ein Bildempfangsmaterial auflaminiert, wobei die strahlungsempfindliche Schicht, sowohl im polymerisierten, wie auch im unpolymerisierten Zustand zur Oberfläche des Bildempfangsmaterials eine größere Haftung aufweist als zum Schichtträger.

Als Bildempfangsmaterial eignen sich Träger wie Papier, Pappe, Metalle, Folien oder Platten aus Polymeren wie z.B. Polyethylen, Polyester, Polyvinylchlorid, Polyamid. Das Bildempfangsmaterial kann unverändert sein oder eine Beschichtung aufweisen die neben den üblichen Bestandteilen weitere Substanzen wie Pigmente, Füller optische Aufheller, UV-Absorber und Antistatikmittel enthalten kann. Dann wird das Material durch den transparenten Schichtträger hindurch unter Verwendung eines gerasterten Farbauszugs-Positivs einer ersten Farbe als Vorlage mit aktinischer Strahlung zur Ausbildung nicht klebriger Bereiche belichtet. Sodann wird der Schichtträger durch Delaminieren entfernt. Das auf dem Bildempfangsmaterial erzeugte latente Bild wird durch Aufbringen eines Toners, der ausschließlich auf den unbelichteten Schichtteilen haftet, sichtbar gemacht. Der Toner wird von den gehärteten Bildteilen entfernt, die dann völlig frei von Toner sind. Man erhält auf diese Weise ein der Vorlage entsprechendes einfarbiges Bild.

Ein zweites Laminat des photopolymerisierbaren Materials wird nach der Entfernung der Deckfolie auf das Bild auflaminiert und unter gleichen Bedingungen durch ein Farbauszugs-Positiv einer zweiten Farbe als Vorlage belichtet und getont. Dieser Vorgang wird dann für einen Farbauszug einer dritten Farbe und falls erwünscht, für einen Schwarzauszug wiederholt.

Man erhält auf diese Weise ein den Vorlagen entsprechendes vierfarbiges Bild.

Anschließend kann auf das Ein- oder Mehrfarbenbild eine Schutzschicht aufgebracht werden, die z.B. aus einem weiteren Laminat des photohärtbaren strahlungsempfindlichen Materials besteht, von dem nach flächenmäßiger Belichtung der Schichtträger entfernt wird.

Bei der Verwendung eines negativ tonbaren, bei Bestrahlung klebrig werdenden Aufzeichnungsmaterials ist die Durchführung eines Farbprüfverfahrens ganz analog, nur daß anstelle von Farbauszugs-Positive Farbauszugs-Negative verwendet werden.

Mit den erfindungsgemäßen tonbaren strahlungsempfindlichen Gemischen bzw. den daraus hergestellten Aufzeichnungsmaterialien lassen sich die beschriebenen Farbprüfverfahren wesentlich einfacher und problemloser durchführen, da beim Abziehen der Deckfolie von der Aufzeichnungsschicht weder Fehlstellen in der Schicht erzeugt werden noch ein Delaminieren von der Trägerschicht erfolgt. Überdies ist eine haftfeste Verbindung der Aufzeichnungsschichten miteinander und auf dem Bildempfangsmaterial gegeben und eine einwandfreie Tonungsqualität gewährleistet. Die erfindungsgemäßen tonbaren strahlungsempfindlichen Gemischen bzw. die daraus hergestellten Aufzeichnungsmaterialien weisen die gewünschte Haftungsbalance schon innerhalb von 4 Tagen nach ihrer Herstellung auf und lassen sich somit unmittelbar nach der Herstellung ausliefern. Darüber hinaus lassen die erfindungsgemäßen tonbaren strahlungsempfindlichen Gemischen die Verwendung von verschiedenen Polypropylenfolien als Deckfolie zu. Weiterhin lassen sich die erfindungsgemäßen tonbaren strahlungsempfindlichen Gemische in verschiedenen Schichtdicken aus einer einheitlichen Gießlösung herstellen.

Die nachfolgenden Beispiele sollen die Erfindung veranschaulichen. Die angegebenen Teile beziehen sich, falls nichts anderes angegeben ist, auf das Gewicht. Die Molekulargewichte der verwendeten Polycaprolactone wurden mittels GPC unter Verwendung eines Polystyrolstandarts bestimmt. Es sind die Gewichtsmittel M_{w} angegeben.

### Beispiel 1 (Vergleichsbeispiel)

Ein aus der EP-A 02 43 933 bekanntes Aufzeichnungsmaterial wurde gemäß der Angabe des Beispiels 7 der genannten Anmeldung hergestellt.
Die 15%ige Beschichtungslösung in Methylenchlorid enthielt:
Diacrylatester eines Bisphenol-A-Epoxydharzes, erhalten aus

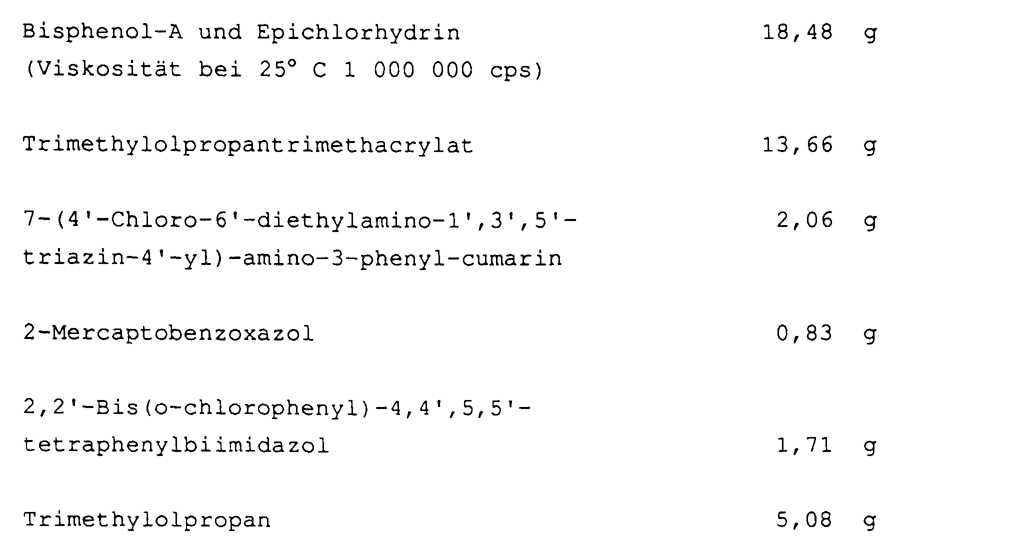

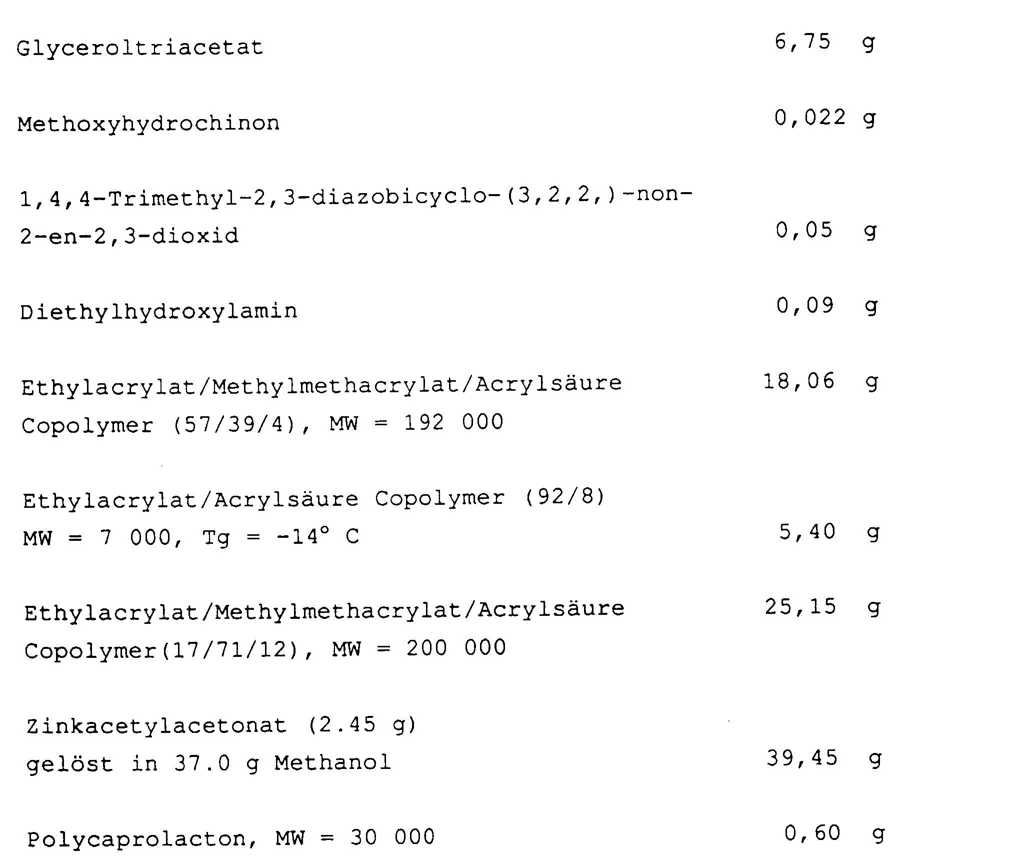

Diese Gießlösung wurde so auf eine Polyethylenterephthalatfolie (12,5 µm) aufgetragen, daß nach dem Trocknen bei 55° C eine 4 µm dicke strahlungsempfindliche Schicht erhalten wurde. Anschließend wurde eine 19 µm starke Deckfolie aus Polypropylen auflaminiert.

### Beispiel 2

Wie in Beispiel 1 beschrieben wurde ein Aufzeichnungsmaterial hergestellt, wobei jedoch in der Gießlösung ein Polycaprolacton mit einem mittleren Molekulargewicht von 120 000 mit einem Gewichtsanteil von 0,9% am tonbaren strahlungsempfindlichen Gemisch an Stelle des Polycaprolactons mit einem mittleren Molekulargewicht von 30 000 enthalten war. Dieses Aufzeichnungsmaterial sowie das Aufzeichnungsmaterial aus Beispiel 1 wurden nach der Herstellung 4 Tagen, 2 und 3 Wochen gelagert, in einem handelsüblichen Laminator eingebaut und nach einer Standzeit von 2 Stunden im warmen Laminator getestet. Die Lufttemperatur im Inneren des Laminators erreichte dabei 45° C. Geprüft wurde, ob sich auf der abgezogenen Deckfolie Rückstände des strahlungsempfindlichen Gemischs befindet.

**Tabelle 1**

| | | | |
|---|---|---|---|
| Alter | 4 | 14 | 21 Tage |
| Aufzeichnungsmaterial Beispiel 1 | - | - | + |
| Aufzeichnungsmaterial Beispiel 2 | + | + | + |

Ein "-" bedeutet, daß Rückstände des strahlungsempfindlichen Gemischs auf der abgezogenen Deckfolie vorhanden sind, ein "+" bedeutet, daß keine solche Rückstände vorhanden sind.

Nur das Aufzeichnungsmaterial aus Beispiel 2 läßt sich schon nach 4 Tagen bestimmungsgemäß verwenden.

### Beispiel 3

Aus den in Beispiel 1 und 2 beschriebenen Beschichtungslösungen wurden jeweils vier Aufzeichnungsmaterialien hergestellt, die nach dem Trocknen photopolymerisierbare Schichten in den Dicken von 3 µm, 4 µm, 6 µm, und 12 µm enthielten. Diese Aufzeichnungsmaterialien wurden 3 Wochen nach der Herstellung wie im Beispiel 2 beschrieben, geprüft.

**Tabelle 2**

| | | | | |
|---|---|---|---|---|
| Schichtdicke | 3 µm | 4 µm | 6 µm | 12 µm |
| Aufzeichnungsmaterial Beispiel 1 | + | + | - | - |
| Aufzeichnungsmaterial Beispiel 2 | + | + | + | + |

Ein "-" bedeutet daß Rückstände des strahlungsempfindlichen Gemischs auf der abgezogenen Deckfolie vorhanden sind, ein "+" bedeutet, daß keine solche Rückstände vorhanden sind.

Nur die unter Verwendung der in Beispiel 2 beschriebenen Gießlösung hergestellten strahlungsempfindlichen Aufzeichnungsmaterialien können aus einer einheitlichen Gießlösung in verschiedenen Schichtdicken hergestellt und bestimmungsgemäß verwendet werden.

### Beispiel 4

Es wurden jeweils zwei wie in Beispiel 1 beschriebene Aufzeichnungsmaterialien (Film A) und zwei wie in Beispiel 2 beschriebene Aufzeichnungsmaterialien (Film B) in einer Schichtdicke der strahlungsempfindlichen Schicht von 4 µm hergestellt, wobei auf die strahlungsempfindliche Schicht jeweils eine von zwei unterschiedlich hergestellten, handelsüblichen Polypropylenfolien auflaminiert wurde. Die Polypropylenfolie PP1 wurde nach dem Schlauchstreckverfahren, die Polypropylenfolie PP2 nach dem Rahmenverstreckungsverfahren hergestellt. Die Kraft, die man benötigt um die Deckfolien und die Polyethylenterephthalatfolie PET von der strahlungsempfindlichen Schicht abzuziehen, wurde wie es in der US 43 26 010 beschrieben ist mit einem Instron® Model 4301 Universal Testinstrument bestimmt, wobei die Deckfolie beziehungsweise die Polyethylenterephthalatfolie unter einen Winkel von ca. 180° zur Kante des Schichtträgers von der Aufzeichnungsschicht abgezogen wurde. Die Messungen wurden an den 21 Tage alten Aufzeichnungsmaterialien sowohl bei 22° C als auch bei 50° C durchgeführt. Die Meßwerte sind in N/mm angegeben. Die Abziehgeschwindigkeit betrug 100 mm / Minute.

**Tabelle 3**

| Folie | PET | | PP1 | | PP2 | |
|---|---|---|---|---|---|---|
| Temperatur | 22° | 50° | 22° | 50° | 22° | 50° |
| Film A | 0,058 | 0,003 | 0,020 | 0,003 | 0,076 | 0,004 |
| Film B | 0,048 | 0,030 | 0,030 | 0,003 | 0,045 | 0,003 |

Bei Film A ist die Haftung von PP2 sowohl bei 22° C als auch bei 50° C sowie von PP1 bei 50° zu hoch relativ zur Haftung der Polyethylenterephtalatfolie, was beim Abziehen der Deckfolie zum Herausreißen von Teilstücken der lichtempfindlichen Schicht führen kann. Bei einer wie in Beispiel 2 beschriebenen Prüfung im Laminator ließen sich beide Polypropylenfolien vom Film B ohne Rückstände des tonbaren strahlungsempfindlichen Gemischs abziehen, von Film A jedoch nur die Polypropylenfolie PP1.

### Beispiel 5

Zur Herstellung eines Vierfarben-Prüfdrucks wurden vier Aufzeichnungsmaterialien gemäß Beispiel 2 und pigmentierte Übertragungsschichten der Farben Cyan, Magenta, Gelb und Schwarz nach der Angabe des Beispiels 12 der DE-C 39 31 493 hergestellt. Ein erstes Aufzeichnungsmaterial wird nach Entfernung der Deckfolie auf ein Bildempfangsmaterial auflaminiert und durch einen gerasterten positiven Cyan-Farbauszug in einem Vakuumkopierrahmen mit einer Metallhalogenidlampe (3 000 Watt) unter Verwendung eines Ultraviolett-durchlässigen Filters 42 s im Abstand von 95 cm belichtet. Nach Entfernung des Schichtträgers wird die Cyan-Übertragungsschicht auf die bildmäßig belichtete Schicht auflaminiert und sofort wieder abgezogen. Die Übertragungsschicht bleibt nur auf den unbelichteten, klebrigen Stellen haften, und man erhält ein positives Cyanbild der Vorlage.

Eine zweite Schicht des positiv tonbaren photopolymerisierbaren Aufzeichnungsmaterials wird auf das Cyanbild auflaminiert und wie oben durch den entsprechenden gerasterten Magenta-Farbauszug belichtet. Nach Entfernung des Schichtträgers wird die Magenta-Übertragungsschicht auf die bildmäßig belichtete Schicht auflaminiert und wieder abgezogen. Die Übertragungsschicht bleibt nur an den unbelichteten klebrigen Stellen haften, und man erhält ein positives Magentabild. Für die Farben Gelb und Schwarz werden die Arbeitsschritte entsprechend wiederholt und anschließend in üblicher Weise eine Schutzschicht aufgebracht. Man erhält einen Vierfarben-Prüfdruck von ausgezeichneter Brillanz und Schärfe mit einer Auflösung von 1% - 99% im 60-Linien/cm-Raster, der eine naturgetreu Wiedergabe des Originals darstellt. Die Deckfolien der Aufzeichnungsmaterialien ließen sich leicht und ohne Fehler abziehen. Die Haftung der Aufzeichnungsschichten untereinander und auf dem Bildempfangsmaterial war ausgezeichnet.

## Patentansprüche

1. Tonbares strahlungsempfindliches Gemisch, enthaltend mindestens eine Verbindung, deren Umsetzung durch Bestrahlung mit aktinischer Strahlung Änderungen der Klebrigkeit des Gemischs hervorruft, einen Photoinitiator oder ein Photoinitiatorsystem, ggf. ein polymeres Bindemittel oder ein Bindemittelgemisch und eine die Adhäsionseigenschaften des Gemischs beeinflussende Verbindung,
dadurch gekennzeichnet, daß
zur Beeinflussung der Adhäsion mindestens ein Polycaprolacton mit einem Gewichtsmittel mittleren Molekulargewicht von mindestens 50 000 enthalten ist.

2. Positiv arbeitendes tonbares photopolymerisierbares Gemisch, enthaltend mindestens eine ethylenisch ungesättigte, photopolymerisierbare Verbindung, einen Photoinitiator oder ein Photoinitiatorsystem, ggf. ein polymeres Bindemittel oder ein Bindemittelsystem und eine die Adhäsionseigenschaften des Gemischs beeinflussende Verbindung,
dadurch gekennzeichnet, daß
zur Beeinflussung der Adhäsion mindestens ein Polycaprolacton mit einem Gewichtsmittel mittleren Molekulargewicht von mindestens 50 000 enthalten ist.

3. Tonbares strahlungsempfindliches Gemisch gemäß Anspruch 1 oder 2,
dadurch gekennzeichnet, daß
ein Polycaprolacton mit einem Gewichtsmittel mittleren Molekulargewicht von 50 000 bis 250 000 verwendet wird.

4. Tonbares strahlungsempfindliches Gemisch gemäß Anspruch 1 oder 2,
dadurch gekennzeichnet, daß
ein Polycaprolacton mit einem Gewichtsmittel mittleren Molekulargewicht von 70 000 bis 180 000 verwendet wird.

5. Tonbares strahlungsempfindliches Gemisch gemäß Anspruch 1 oder 2,
dadurch gekennzeichnet, daß
ein Polycaprolacton mit einem Gewichtsmittel mittleren Molekulargewicht von 100 000 bis 130 000 verwendet wird.

6. Tonbares strahlungsempfindliches Gemisch gemäß einem der Ansprüche 1 bis 5,
dadurch gekennzeichnet, daß
ein Polycaprolacton in einer Menge von höchstens 5 Gewichtsprozent bezogen auf das tonbare lichtempfindliche Gemisch enthält.

7. Tonbares strahlungsempfindliches Gemisch gemäß einem der Ansprüche 1 bis 5,
dadurch gekennzeichnet, daß
ein Polycaprolacton in einer Menge von höchstens 2 Gewichtsprozent bezogen auf das tonbare lichtempfindliche Gemisch enthält.

8. Strahlungsempfindliches Aufzeichnungsmaterial, bestehend aus einem Schichtträger, einer tonbaren strahlungsempfindlichen Schicht und einer Deckfolie
dadurch gekennzeichnet, daß
die strahlungsempfindliche Schicht aus einem tonbaren strahlungsempfindlichen Gemisch gemäß Anspruch 1 bis 7 besteht.

9. Verfahren zur Herstellung von Bildern bei dem
a) auf einen Bildträger ein strahlungsempfindliches Aufzeichnungsmaterial gemäß Anspruch 8 nach Entfernen der Deckfolie aufgebracht wird,
b) die strahlungsempfindliche Schicht durch den Schichtträger bildmäßig belichtet wird,
c) der Schichtträger abgezogen wird und
d) auf die klebrigen Bereiche der belichteten Schicht ein Tonermaterial aufgebracht wird.

10. Verfahren nach Anspruch 9,
dadurch gekennzeichnet, daß
die Schritte a) bis d) mehrfach wiederholt werden, wobei unter a) das neue strahlungsempfindliche Aufzeichnungsmaterial auf die gemäß den vorhergehenden Schritten behandelte strahlungsempfindliche Schicht aufgebracht wird, unter b) bei jeder Wiederholung von Schritt b) ein anderes Bild aufbelichtet wird und unter d) bei jeder Wiederholung von Schritt d) ein andersfarbiges Tonermaterial verwendet wird und sich ein Mehrfarbenbild ergibt.

11. Verfahren nach Anspruch 9 oder 10,
dadurch gekennzeichnet, daß
vor der bildmäßigen Belichtung der Schichtträger entfernt wird.

## Claims

1. Tonable, photosensitive composition comprising at least one compound that reacts to actinic radiation by causing modifications in the tackiness of the composition, a photoinitiator or a photoinitiator system, optionally a polymeric binder or a binder mixture, and a compound that influences the adhesion properties of the composition,
characterized in that,
it contains at least one polycaprolactone with a weight average molecular weight of at least 50000 to influence the adhesion.

2. Positive-working, tonable, photopolymerizable composition comprising at least one ethylenically unsaturated, photopolymerizable compound, a photoinitiator or a photoinitiator system, optionally a polymeric binder or a binder mixture, and a compound that influences the adhesion properties of the composition,
characterized in that,
it contains at least one polycaprolactone with a weight average molecular weight of at least 50000 to influence the adhesion.

3. Tonable, photosensitive composition according to claim 1 or 2, characterized in that,
a polycaprolactone with a weight average molecular weight of 50000 to 250000 is used.

4. Tonable, photosensitive composition according to claim 1 or 2, characterized in that,
a polycaprolactone with a weight average molecular weight of 70000 to 180000 is used.

5. Tonable, photosensitive composition according to claim 1 or 2, characterized in that,
a polycaprolactone with a weight average molecular weight of 100000 to 130000 is used.

6. Tonable, photosensitive composition according to claim 1 or 5, characterized in that,
it contains a polycaprolactone in the amount of up to a maximum of 5 % by weight, relative to the tonable, photosensitive composition.

7. Tonable, photosensitive composition according to claim 1 or 5, characterized in that,
it contains a polycaprolactone in the amount of up to a maximum of 2 % by weight, relative to the tonable, photosensitive composition.

8. Photosensitive recording material comprising a support, a tonable, photosensitive layer, and a cover film,
characterized in that,
the photosensitive layer consists of a tonable, photosensitive composition according to one of the claims 1 to 7.

9. Process for making images wherein
a) a photosensitive recording element according to claim 8 is applied onto an image receptor after remove of the cover film,
b) the photosensitive layer is imagewise exposed through the support,
c) the support is stripped of, and
d) a toner is applied onto the tacky areas of the exposed layer.

10. Process according to claim 9, characterized in that, steps a) through d) are repeated at least once such that in a) a different photosensitive recording element is applied onto the photosensitive layer treated according to the foregoing steps, in b) for each repeat of step b) the photosensitive layer is imagewise exposed through a different transparency, and in d) for each repeat of step d) a different color toner material is used, and a polychromatic image is produced.

11. Process according to claim 9 to 10, characterized in that, the support is removed before the imagewise exposure.

## Revendications

1. Mélange photosensible pigmentable contenant au moins un dérivé dont la réaction par exposition à l'aide d'une radiation actinique provoque des modifications du pouvoir collant du mélange, un photoinitiateur ou un système photoinitiateur, le cas échéant, un liant polymère ou un mélange de liants et un dérivé pouvant agir sur les propriétés d'adhérence du mélange caractérisé en ce que, pour influer sur l'adhérence, il contient au moins une polycaprolactone d'un poids moléculaire d'au moins 50 000.

2. Mélange photopolymérisable pigmentable fonctionnant en positif contenant au moins un dérivé photopolymérisable insaturé éthyléniquement, un photoinitiateur ou un système photoinitiateur, le cas échéant un liant ou un système de liant polymère et un dérinvé pouvant agir sur les propriétés d'adhérence du mélange, caractérisé en ce qu'il contient, pour agir sur l'adhérence, au moins une polycaprolactone d'un poids moléculaire moyen d'au moins 50 000.

3. Mélange photosensible pigmentable selon la revendication 1 ou 2, caractérisé en ce que l'on utilise une caprolactone d'un poids moléculaire moyen en poids de 50 000 à 250 000.

4. Mélange photosensible pigmentable selon la revendication 1 ou 2, caractérisé en ce que l'on utilise une polycaprolactone d'un poids moléculaire moyen en poids de 70 000 à 180 000.

5. Mélange photosensible pigmentable selon la revendication 1 ou 2, caractérisé en ce que l'on emploie une caprolactone d'un poids moléculaire moyen en poids de 100 000 à 130 000.

6. Mélange photosensible pigmentable selon l'une quelconque des revendications 1 à 5, caractérisé en ce qu'il contient une polycaprolactone en proportion au maximum de 5 % en poids par rapport au mélange photosensible pigmentable.

7. Mélange photosensible pigmentable selon l'une quelconque des revendications 1 à 5, caractérisé en ce qu'il contient une polycaprolactone en proportion au maximum de 2 % en poids par rapport au poids du mélange photoscnsible pigmentable.

8. Matériau graphique photosensible constitué d'une couche porteuse, d'une couche photosensible pigmentable et d'un film de protection, caractérisé en ce que la couche photoscnsible est constituée d'un mélange photosensible pigmentable selon l'une quelconque des revendications 1 à 7.

9. Procédé d'obtention d'image dans lequel :
a) sur un support d'image est appliqué un matériau graphique photosensible selon la revendication 8 après élimination du film protecteur,
b) la couche photosensible est exposée à une image à travers la couche porteuse,
c) la couche porteuse est retirée, et
sur les zones collantes de la couche exposée, on applique un toner.

10. Procédé selon la revendication 9, caractérisé en ce que les étapes a) à b) sont répétées plusieurs fois, en a) le nouveau matériau graphique photosensible est appliqué sur la couche photosensible traitée selon les étapes précédentes, et en b) pour chaque répétition de l'étape d), une autre image est exposée, et en b) pour chaque répétition de l'étape d), un matériau toner d'une autre couleur est utilisé et il en résulte une image polychrome.

11. Procédé selon la revendication 9 ou 10, caractérisé en ce que la couche porteuse est retirée avant l'exposition à une image.
